(19) Europäisches Patentamt
European Patent Office
Office européen des brevets

(11) EP 4 224 178 A1

(12) **EUROPÄISCHE PATENTANMELDUNG**

(43) Veröffentlichungstag:
**09.08.2023 Patentblatt 2023/32**

(21) Anmeldenummer: **22154952.0**

(22) Anmeldetag: **03.02.2022**

(51) Internationale Patentklassifikation (IPC):
**G01R 31/28** (2006.01)    **G01R 31/316** (2006.01)

(52) Gemeinsame Patentklassifikation (CPC):
**G01R 35/005; G01R 19/2509; G01R 31/316;**
G01R 31/2837; G01R 31/2846

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Bronner, Johanna**
**80337 München (DE)**

• **Fischer, Peter**
**92421 Schwandorf (DE)**
• **Griessbach, Gunter**
**09423 Gelenau (DE)**
• **Lebacher, Michael**
**84513 Töging am Inn (DE)**
• **Rieskamp, Timo**
**90408 Nürnberg (DE)**
• **Wabro, Lukas**
**92224 Amberg (DE)**
• **Weikert, Robert**
**92342 Burggriesbach (DE)**

(74) Vertreter: **Siemens Patent Attorneys**
**Postfach 22 16 34**
**80506 München (DE)**

(54) **KALIBRIERUNG EINER ELEKTRONISCHEN BAUGRUPPE WÄHREND EINES FERTIGUNGSPROZESSES**

(57) Verfahren zur Kalibrierung einer elektronischen Baugruppe während eines Fertigungsprozesses (40), mit den Schritten:
- Ermitteln (S1) eines Kalibrierwertes (44) für die Baugruppe (41), der bei einem vorgegebenen Eingabewert eine Abweichung zwischen einem von der Baugruppe (41) ausgegebenen Ist-Ausgabewert und einem vorgegebenen Soll-Ausgabewert angibt,
- Übermitteln (S2) des Kalibrierwertes an (44) die Baugruppe (41), und
- Speichern (S3) des Kalibrierwertes (44) in der Baugruppe (41),
wobei der Kalibrierwert (44) der Baugruppe (41) mittels eines in einer Kalibriervorrichtung (47) ausgeführten maschinellen Lernverfahrens (42) ermittelt wird, und das maschinelle Lernverfahren (42) anhand von Trainingsdaten, die historische Kalibrierwerte (32) einer Mehrzahl von gleichartigen Baugruppen sowie fertigungsbedingte und/oder physikalische Eigenschaften ausdrückende Parameter (34) der gleichartigen Baugruppen umfassen, trainiert ist.

FIG 4

EP 4 224 178 A1

**Beschreibung**

Die Erfindung betrifft ein Verfahren zur Kalibrierung einer elektronischen Baugruppe während eines Fertigungsprozesses, sowie eine Kalibrieranordnung mit einer Kalibriervorrichtung und einer zu kalibrierenden elektronischen Baugruppe.

Elektronischen Baugruppen werden häufig in hoher Stückzahl hergestellt und müssen unterschiedliche Anforderungen in Bezug auf ihre Messgenauigkeit erfüllen. Hierzu wird in einer Fertigungslinie nach einem Zusammenbau und einer Programmierung der Baugruppe eine gesonderte Kalibrierstation in die Fertigungslinie eingebracht. In der Kalibierstation werden mit hochgenauen Messinstrumenten definierte Spannungs- und Stromwerte der Baugruppe vorgegeben, die Differenz und daraus ein Kalibrierwert ermittelt und in Firmware der Baugruppe für alle nachfolgenden Messungen abgespeichert.

Sind beispielsweise bei einer Analog-Baugruppe mehrere Kanäle vorhanden oder sind mehrere Eingangsschaltkreise verbaut, sind entsprechend viele zeitaufwändige Messungen vorzunehmen, da der Kalibrierwert von Kanal zu Kanal unterschiedlich sein kann. Außerdem kann es notwendig sein, die Kanäle in verschiedenen Messbereichen zu kalibrieren. Da die Kalibrierungszeit massiv mit der Anzahl von Kanälen einer Baugruppe sowie der Anzahl an Messarten und Messbereiche skaliert ist jeder Hersteller bestrebt, diese meist für die Fertigungslinie taktgebenden Zeiten zu reduzieren.

Mit speziellen Kenntnissen ist es möglich, einzelne Kalibrierungsschritte durch eine intelligente Kombinatorik einzusparen und so den Kalibrierungsvorgang zu optimieren. Wird eine gewisse Verstärkung des Analog-Eingangsschaltkreises beispielsweise in mehreren Messarten (Spannung, Strom, Temperatur) verwendet, reicht es unter Umständen aus, die Verstärkung nur in einer dieser Messarten zu kalibrieren und den Kalibrierwert intern für die anderen Messarten und/oder Messbereiche zu verwenden. Dies führt jedoch häufig zu einer verminderten oder schwankenden Genauigkeit der Schaltkreise innerhalb einer Baugruppe.

Es ist somit eine Aufgabe der vorliegenden Erfindung, ein Verfahren zu schaffen, bei dem die Dauer des Kalibriervorgangs verkürzt und eine gleichbleibende Produktqualität in Bezug auf eine Messgenauigkeit erreicht wird.

Die Aufgabe wird durch die in den unabhängigen Ansprüchen beschriebenen Maßnahmen gelöst. In den Unteransprüchen sind vorteilhafte Weiterbildungen der Erfindung dargestellt.

Gemäß einem ersten Aspekt betrifft die Erfindung ein Verfahren zur Kalibrierung einer elektronischen Baugruppe während eines Fertigungsprozesses, mit den Schritten:

- Ermitteln eines Kalibrierwertes für die Baugruppe, der bei einem vorgegebenen Eingabewert eine Abweichung zwischen einem von der Baugruppe ausgegebenen Ist-Ausgabewert und einem vorgegebenen Soll-Ausgabewert angibt,
- Übermitteln des Kalibrierwertes an die Baugruppe, und
- Speichern des Kalibrierwertes in der Baugruppe,

wobei der Kalibrierwert der Baugruppe mittels eines in einer Kalibriervorrichtung ausgeführten maschinellen Lernverfahrens ermittelt wird, und das maschinelle Lernverfahren anhand von Trainingsdaten, die historische Kalibrierwerte einer Mehrzahl von gleichartigen Baugruppen sowie fertigungsbedingte und/oder physikalische Eigenschaften ausdrückende Parameter der gleichartigen Baugruppen umfassen, trainiert ist.

Anhand der genannten Trainingsdaten können fertigungsbedingte physikalische Zusammenhänge und Ähnlichkeiten im Fertigungsprozess der Baugruppen durch das maschinelle Lernverfahren modelliert werden und ein Erwartungswert für den Kalibrierwert einer zu kalibrierenden Baugruppe ermittelt werden. Dieser Erwartungswert wird als Kalibrierwert vom maschinellen Lernverfahren ausgegeben. Durch das maschinelles Lernverfahren kann der Zeitaufwand für den Kalibriervorgang reduziert werden und somit bei gleichbleibender Produktqualität eine Kosteneinsparung in der Produktion erreicht werden. Langfristige Forschungs- und Entwicklungserkenntnisse bei der Herstellung der Baugruppe und/oder deren Bauteile können zum Optimieren des Produktionsprozesses einbezogen werden.

In einer vorteilhaften Ausführungsform umfassen die Trainingsdaten zusätzlich fertigungsbedingte und/oder physikalische Eigenschaften ausdrückende Parameter mindestens eines Bauteils der Baugruppe.

Somit können auch fertigungsbedingte und/oder physikalische Eigenschaften von Bauteilen der Baugruppe im maschinellen Lernverfahren modelliert werden und somit auch Eigenschaften von zugelieferten Bauteilen berücksichtigen. Ein oder mehrere Bauteile werden beispielsweise in jeweils eigenständigen Fertigungsprozessen hergestellt und können unterschiedlichen Einflüssen unterworfen sein. Bei der Fertigung des Bauteils können unterschiedliche Materialien oder Einzelteile mit unterschiedlichen Parametern, wie Chargennummer oder Dicke eines Halbleiter-Bauelemente, verwendet werden. Somit können tiefere Einblicke in Bezug auf Produktqualität sowie Bauteiltendenzen erhalten werden.

In einer vorteilhaften Ausführungsform umfassen die Trainingsdaten zusätzlich physikalische Eigenschaften ausdrückende Parameter einer Fertigungsumgebung der gleichartigen Baugruppe.

Somit kann der Einfluss von unterschiedlichen Gegebenheiten in der Fertigungsumgebung, wie beispielsweise hohe oder niedrige Umgebungstemperaturen, bei der Ermittlung des Kalibrierwertes berücksichtigt werden.

In einer vorteilhaften Ausführungsform umfasst die Baugruppe mehr als eine zu kalibrierende Baugruppenkomponente und für jede einzelne der Baugruppenkomponenten wird der Kalibrierwert von der Kalibriervorrichtung ermittelt und an die Baugruppe übermittelt.

Dies ermöglicht eine individuelle Kalibrierung für jede Baugruppenkomponente.

In einer vorteilhaften Ausführungsform wird eine Kalibrierabfragekennung von der zu kalibrierenden Baugruppe in der Kalibriervorrichtung empfangen wird und der Kalibrierwert abhängig von der übermittelten Kalibrierabfragekennung von der Kalibriervorrichtung an die zu kalibrierende Baugruppe übermittelt, wobei die Kalibrierabfragekennung mindestens einem der Parameter der Trainingsdaten zuordenbar ist.

Die Kalibrierabfragekennung wird somit von der Baugruppe an die Kalibriervorrichtung übermittelt und initiiert die Ermittlung des Kalibrierwertes. Die Kalibrierabfragekennung kennzeichnet einerseits die Baugruppe, für die der Kalibrierwert angefordert wird und umfasst mindestens einen fertigungsbedingte und/oder physikalische Eigenschaften ausdrückenden Parameter der Baugruppe, wobei dieser Parameter zum Trainieren des maschinellen Lernverfahrens verwendet wurde. Das trainierte maschinelle Lernverfahren ermittelt abhängig von der Kalibrieranfragekennung den Kalibrierwert für die anfragende, zu kalibrierende Baugruppe.

In einer vorteilhaften Ausführungsform wird eine Kalibrierabfragekennung von der zu kalibrierenden Baugruppe in der Kalibriervorrichtung empfangen und der Kalibrierwert abhängig von der übermittelten Kalibrierabfragekennung von der Kalibriervorrichtung an die zu kalibrierende Baugruppe übermittelt wird, wobei die Kalibrierabfragekennung einen für eine der Baugruppenkomponenten der zu kalibrierenden Baugruppe durch Messen ermittelten Kalibrierwert umfasst.

Der für eine der Baugruppenkomponenten der zu kalibrierenden Baugruppe durch Messen ermittelten Kalibrierwert wird als weiterer Eingabeparameter an das trainierte maschinelle Lernverfahren übermittelt. Das trainierte maschinelle Lernverfahren kann durch diesen zusätzlichen Eingabewert für die weiteren Komponenten der Baugruppe einen Kalibrierwert mit höherer Genauigkeit ermitteln und ausgegeben.

In einer vorteilhaften Ausführungsform wird eine mit dem gespeicherten Kalibrierwert erreichte Genauigkeit der kalibrierten Baugruppe und/oder der kalibrierten Baugruppenkomponente ermittelt und abhängig von der ermittelten Genauigkeit ein Gütewert der Baugruppe und/oder der kalibrierten Baugruppenkomponente zugeordnet.

Somit kann die mit dem gespeicherten Kalibrierwert tatsächliche erreichte Genauigkeit der kalibrierten Baugruppe bzw. Baugruppenkomponenten ermittelt werden und dem Anwender der Baugruppe zugesichert werden. Somit können Baugruppen bzw. Baugruppenkomponenten je nach Gütewert gezielt für Anwendung mit unterschiedlichen Anforderungen an die Ausgabegenauigkeit eingesetzt werden.

In einer vorteilhaften Ausführungsform wird der mindestens eine in der Baugruppe gespeicherte Kalibrierwert erst nach einer erfolgreichen Freischaltaktion zur Nutzung in der Baugruppe freigeben.

Somit ist eine Nachkalibrierung der Baugruppe beim Kunden möglich.

In einer vorteilhaften Ausführungsform ist jeweils ein Kalibrierwert für eine oder ein Kalibrierwert für mehrere Baugruppenkomponenten und/oder jeweils ein Kalibrierwert für eine Messgröße oder ein Kalibrierwert für mehrere unterschiedliche Messgrößen der Baugruppenkomponente freigebbar.

Dies ermöglicht eine flexible und bezüglich der Ausgabegenauigkeit Bedarfsbezogene Nutzung der Baugruppe bzw. deren Komponenten.

In einer vorteilhaften Ausführungsform wird der mindestens eine Kalibrierwert durch Empfangen eines für die Baugruppe spezifischen kryptographischen Schlüssels in der Baugruppe aktiviert.

Der kryptographische Schlüssel ermöglicht einerseits eine Manipulationsgeschützte Speicherung des Kalibrierwertes in der Baugruppe. Durch den kryptographischen Schlüssel kann eine verbesserte Messgenauigkeit als Leistungsmerkmal der Baugruppe einfach an einen Benutzer bereitgestellt werden.

In einer vorteilhaften Ausführungsform werden jeweils ein Kalibrierwert für mehr als eine unterschiedliche Genauigkeitsstufe der Baugruppe von der Kalibriervorrichtung ermittelt und auf der Baugruppe gespeichert, und auf Anforderung ein von dem auf der Baugruppe aktiver Kalibrierwert unterschiedlicher Kalibrierwert freigebbar ist.

Dies ermöglicht eine Nachkalibrierung der Baugruppe nach dem Fertigungsprozess. Je nach Bedarf kann der Kalibrierwert für die gewünschte Genauigkeitsstufe in die Baugruppe geladen werden.

Gemäß einem zweiten Aspekt betrifft die Erfindung eine Kalibriervorrichtung zur Kalibrierung einer elektronischen Baugruppe während eines Fertigungsprozesses, umfassend

- eine Kalibriereinheit, die derart ausgebildet ist, einen Kalibrierwert für die Baugruppe, der bei einem vorgegebenen Eingabewert eine Abweichung zwischen einem von der Baugruppe ausgegebenen Ist-Ausgabewert und einem vorgegebenen Soll-Ausgabewert angibt, zu ermitteln, und
- eine Ausgabeeinheit, die derart ausgebildet ist,

den Kalibrierwert an die Baugruppe zu übermitteln, wobei der Kalibrierwert der Baugruppe mittels eines in der Kalibriervorrichtung ausgeführten maschinellen Lernverfahrens ermittelt wird, und das maschinelle Lernverfahren anhand von Trainingsdaten, die historische Kalibrierwerte einer Mehrzahl von gleichartigen Baugruppen sowie fertigungsbedingte und/oder physikalische Eigenschaften ausdrückende Parameter der gleichartigen Baugruppen umfassen, trainiert ist.

Die Kalibriervorrichtung ermöglicht durch das in der Kalibriereinheit ausgebildete maschinelle Lernverfahren eine präzise Ermittlung des Kalibrierwertes ohne Messungen an der zu kalibrierenden Baugruppe durchführen zu müssen. Dies verkürzt den Kalibriervorgang während der Fertigung. Die Kalibriervorrichtung kann räumlich von der Fertigungsanlage abgesetzt angeordnet sein. Beispielsweise kann die Kalibriervorrichtung durch einen Server in einer Server-Cloud ausgebildet sein und den Kalibrierwert über eine Datenverbindung an die Fertigungsanlage und weiter an die Baugruppe übermitteln. Dies ermöglicht es eine zentrale Kalibriervorrichtung für mehrere, auch räumlich getrennt ausgeführte Fertigungsprozesse, z.B. in unterschiedlichen Fertigungsanlagen zu verwenden.

Gemäß einem dritten Aspekt betrifft die Erfindung elektronische Baugruppe, umfassend

- eine Eingabeschnittstelle, die derart ausgebildet ist, einen Kalibrierwert für die Baugruppe, der bei einem vorgegebenen Eingabewert eine Abweichung zwischen einem von der Baugruppe ausgegebenen Ist-Ausgabewert und einem vorgegebenen Soll-Ausgabewert angibt, von einer Kalibriervorrichtung zu empfangen,
- eine Speichereinheit, die derart ausgebildet ist, den Kalibrierwert in der Baugruppe zu speichern, wobei der Kalibrierwert der Baugruppe mittels eines in der Kalibriervorrichtung ausgeführten maschinellen Lernverfahrens ermittelt wird, und das maschinelle Lernverfahren anhand von Trainingsdaten, die historische Kalibrierwerte einer Mehrzahl von gleichartigen Baugruppe sowie fertigungsbedingten und/oder physikalischen Eigenschaften ausdrückenden Parametern der gleichartigen Baugruppen umfassen, trainiert ist, und
- eine Ausgabeschnittstelle, die derart ausgebildet ist,

eine Kalibrierabfragekennung von der Baugruppe an die Kalibriervorrichtung zu senden, wobei dem Kalibrierabfragekennung mindestens einer der Parameter der Trainingsdaten zuordenbar ist.

Die elektrische Baugruppe ist bezüglich der Kalibrierung besonders flexibel. So kann die Baugruppe während des Fertigungsprozesses durch Kommunikation mit der Kalibriervorrichtung kalibriert werden. Die Messgenauigkeit bzw. der Kalibrierwert der Baugruppe kann nach dem Fertigungsprozess freigeschaltet oder geändert werden.

Ein vierter Aspekt der Erfindung betrifft eine Kalibriersystem, umfassend eine erfindungsgemäße Kalibriervorrichtung und mindesten ein zu kalibrierende Baugruppe, die derart ausgebildet sind das erfindungsgemäße Verfahren auszuführen.

Ein fünfter Aspekt der Erfindung betrifft ein Computerprogrammprodukt, umfassend ein nicht flüchtiges computerlesbares Medium, das direkt in einen Speicher eines digitalen Computers ladbar ist, umfassend Programmcodeteile, die bei Ausführung der Programmcodeteile durch den digitalen Computer diesen veranlassen, die Schritte des Verfahrens durchzuführen.

Sofern es in der nachfolgenden Beschreibung nicht anders angegeben ist, beziehen sich die Begriffe "ermitteln", "übermitteln", "speichern und dergleichen, vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt werden oder vorliegen können, beispielsweise als elektrische Impulse. Die Anordnung und darin optional enthaltene Komponenten, wie beispielsweise die Kalibriereinheit oder die Speichereinheit und dergleichen kann bzw. können einen oder mehrere Prozessoren, umfassen. Bei einem Prozessor kann es sich insbesondere um einen Hauptprozessor (engl. Central Processing Unit, CPU), einen Mikroprozessor oder einen Mikrokontroller, beispielsweise eine anwendungsspezifische integrierte Schaltung oder einen digitalen Signalprozessor, möglicherweise in Kombination mit einer Speichereinheit zum Speichern von Programmbefehlen, etc. handeln.

Ein Computerprogrammprodukt, wie z. B. ein Computerprogrammmittel, kann beispielsweise als Speichermedium, wie zum Beispiel einer Speicherkarte, USB-Stick, CD-ROM, DVD oder auch in Form einer herunterladbaren Datei von einem Server in einem Netzwerk bereitgestellt oder geliefert werden.

Ausführungsbeispiele des erfindungsgemäßen Verfahrens und der erfindungsgemäßen Anordnung sind in den Zeichnungen beispielhaft dargestellt und werden anhand der nachfolgenden Beschreibung näher erläutert. Es zeigen:

Fig. 1    ein Beispiel eines herkömmlichen Verfahrens zur Kalibrierung einer Baugruppe in schematischer Darstellung;

Fig. 2    ein Beispiel einer Baugruppe mit mehreren Eingangskanälen bzw. Messgrößen in schematischer Darstellung;

Fig. 3    ein erstes Ausführungsbeispiel des erfindungsgemäßen Kalibrierverfahrens als Ablaufdiagram;

Fig. 4    ein zweites Ausführungsbeispiel des erfindungsgemäßen Kalibrierverfahrens innerhalb des Fertigungsprozesses in schematischer Darstellung;

Fig. 5    ein drittes Ausführungsbeispiel des erfindungsgemäßen Kalibrierverfahrens mit gemessenem Kalibrierwert für eine Baugruppenkomponente innerhalb des Fertigungsprozesses in schematischer Darstellung;

Fig. 6    ein viertes Ausführungsbeispiel des erfindungsgemäßen Kalibrierverfahrens mit einer Anforderung eines Kalibrierwertes nach dem Fertigungsprozess; und

Fig. 7    einem Ausführungsbeispiel einer erfindungsgemäßen Kalibrieranordnung in Blockdarstellung.

Einander entsprechende Teile sind in allen Figuren mit den gleichen Bezugszeichen versehen.

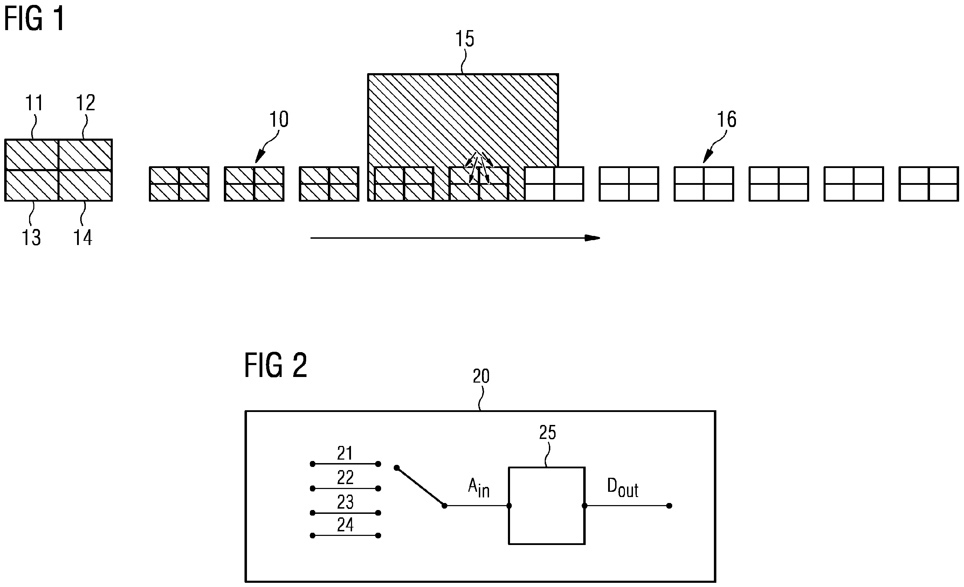

Zur Veranschaulichung wird in Fig. 1 ein herkömmlicher Kalibriervorgang während eines Fertigungsprozesses dargestellt. Bei dem Fertigungsprozess werden montierte, aber unkalibrierte Baugruppen 10, der unkalibrierte Zustand ist durch Schraffur gekennzeichnet, einer Kalibrierstation 15 zugeführt. Die Baugruppe 10 besteht aus mehreren, beispielsweise vier Baugruppenkomponenten 11, 12, 13, 14. Die Baugruppe 10 kann beispielsweise ein Eingabebaugruppe einer Speicherprogrammierbare Steuerung sein, die eine sehr hohe Anforderung in Bezug auf die zu erreichende Messgenauigkeit hat.

Eine als Eingabebaugruppe 20 ausgebildete Baugruppe ist in Fig. 2 dargestellt. Die Eingangsbaugruppe 20 umfasst mehrere Baugruppenkomponenten, die jeweils als ein Kanal 21, 22, 23, 24 eines Eingangsschaltkreis ausgebildet sind, und einen Analog-Digital-Konverter 25. Ein über einen der Kanäle 21, 22, 23, 24 zugeführtes analoges Eingangssignal Ain wird vom Analog-Digital-Konverter 25 gewandelt ein digitales Ausgangssignal Dout wird ausgegeben.

Beim Kalibrieren in der Kalibrierstation 15 wird eine definierte, vorgegebene Eingangsgröße als Eingabewert auf den Eingang des Eingangsschaltkreises, hier Kanal 21, angelegt und ein gemessener Ausgangswert des Ausgangssignal mit einem vorgegebenen Sollwert verglichen. Aus der Abweichung zwischen dem gemessenen Ausgangswert bei einem definierten Eingabewert und dem Sollwert werden Korrekturwerte bestimmt. Diese Korrekturwerte werden als Kalibrierwerte in der Baugruppe gespeichert und im späteren Betrieb der Speicherprogrammierbare Steuerung als Korrekturwerte für die Eingangsschaltkreise herangezogen. Eine kalibrierte Baugruppe 16 mit gespeicherten Kalibrierwerten verlässt die Kalibrierstation 15. In den Figuren werden kalibrierte Baugruppen ohne Schraffur dargestellt.

Sind bei der Eingangsbaugruppe 20, wie dargestellt, mehrere Kanäle 21, 22, 23, 24 vorhanden oder sind mehrere Eingangsschaltkreise verbaut, sind entsprechend viele zeitaufwändige Messungen vorzunehmen, da der Kalibrierwert von Kanal zu Kanal unterschiedlich sein kann. Außerdem kann es notwendig sein, die Kanäle in verschiedenen Messbereichen zu kalibrieren. Dies führt in der Produktion der Baugruppen zu hohen Kosten.

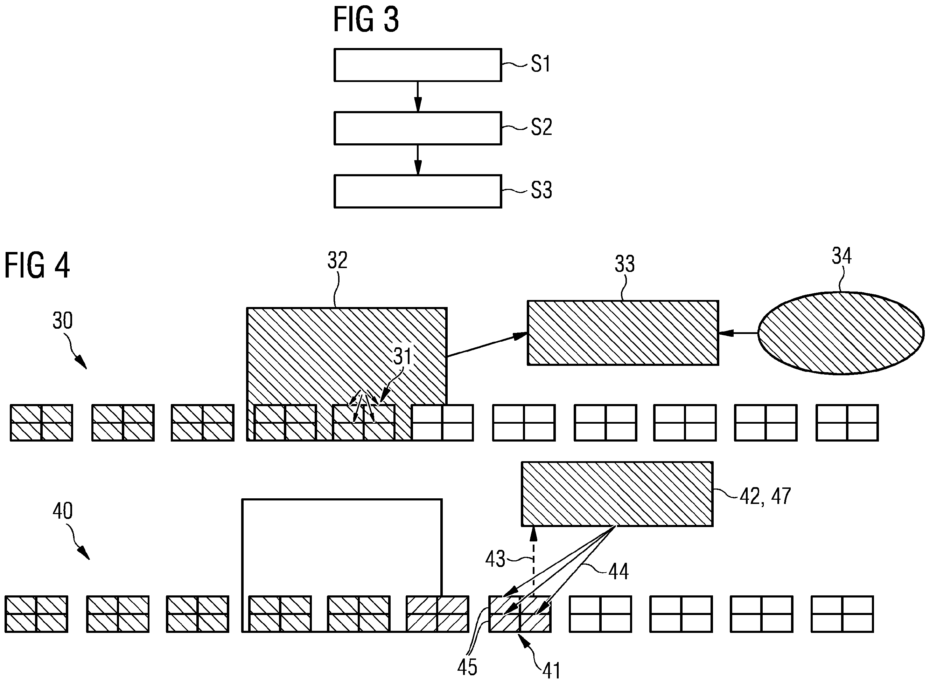

Anhand von Fig. 3 wird nun ein Kalibrierverfahren für eine elektronische Baugruppe während eines Fertigungsprozesses erläutert, das eine signifikante Reduktion der für den Kalibrierungsvorgang benötigten Zeit ermöglicht, eine hinreichende Genauigkeit bezüglich der Kalibrierwerte liefert, sowie eine objektive Evaluierung des verwendeten trainierten maschinellen Lernverfahrens einbezieht.

In einem ersten Verfahrensschritt S1 wird ein Kalibrierwert für die Baugruppe ermittelt. Der Kalibrierwert gibt bei einem vorgegebenen Eingabewert eine Abweichung zwischen einem von der Baugruppe ausgegebenen Ist-Ausgabewert und einem vorgegebenen Soll-Ausgabewert an. Der Kalibrierwert der Baugruppe wird mittels eines in einer Kalibriervorrichtung ausgeführten maschinellen Lernverfahrens ermittelt. Das maschinelle Lernverfahren ist anhand von Trainingsdaten, die historische Kalibrierwerte einer Mehrzahl von gleichartigen Baugruppen sowie fertigungsbedingte und/oder physikalische Eigenschaften ausdrückende Parameter der gleichartigen Baugruppen umfassen, trainiert. Die Trainingsdaten können zusätzlich fertigungsbedingte und/oder physikalische Eigenschaften ausdrückende Parameter mindestens eines k der Baugruppe und/oder physikalische Eigenschaften ausdrückende Parameter einer Fertigungsumgebung der gleichartigen Baugruppe umfassen.

Anschließend, siehe Verfahrensschritt S2, wird der ermittelte Kalibierwert an die Baugruppe übermittelt und in der Baugruppe abgespeichert, siehe Verfahrensschritt S3.

Da bei den zu kalibrierenden Baugruppen fertigungsbedingte physikalische Zusammenhänge und Ähnlichkeiten durch den Fertigungsprozess, die Fertigungsumgebung, oder durch das zur Herstellung für einzelne Bauteile der Baugruppe verwendete Material bestehen, ist es möglich diese Zusammenhänge durch das maschinelle Lernverfahren zu modellieren und einen Erwartungswert für den Kalibrierwert zu ermitteln, der dann als Kalibrierwert ausgegeben wird.

Das maschinelle Lernverfahren kann beispielsweise als ein tiefes Neuronale Netzwerk, ein generalisiertes nichtlineares Regressionsmodelle, oder ähnliches ausgebildet sein. Das maschinelle Lernverfahren

$$f(X) = \hat{y} \approx y$$

ermittelt aus Inputdaten $X \in \mathbb{R}^p$ geschätzte Kalibrierwerte $\hat{y} \in \mathbb{R}^q$, wobei $\hat{y}$ die vorhergesagten Korrekturwerte angibt unddie Korrekturwerte bei physischer Kalibration, d.h. durch Messung des tatsächlichen Ist-Ausgabewertes und Bestimmung der Abweichung zu einem vorgegebenen Soll-Ausgabewertes bei einem vorgegebenen Eingabewert. Dabei ist es möglich im p-dimensionalen Inputdatenraum $X$ sowohl historische Kalibrierwerte sowie weitere Informationen über Produktionsparameter, Umgebungsgrößen, Herstellungsprozess von Baugruppenkomponenten, insbesondere auch von Zulieferteilen, sowie Informationen über verwendetes Material, beispielsweise eine Position innerhalb eines Wafers eines Halbleiterbauteils und/oder andere Einflussparameter zu nutzen, um eine möglichst präzise Prädiktion für die Kalibrierwerte y zu erreichen.

Präzise Vorhersagen des Kalibrierwertes werden in dem beispielsweise als Neuronales Netzwerk ausgebildeten maschinellen Lernverfahren durch Minimieren eines Distanzmaßes $d(y,f(X))$, beispielsweise einer euklidischen Distanz oder einer $L_1$-Distanz über beispielsweise einen Gradientenabstieg ermittelt. Diese Methoden decken auch den Fall einer Unteridentifikation ab (p<q), so dass es möglich wird mit einem niedrigdimensionalem Inputraum X auf einen höher-dimensionalen Outputraum y zu schließen.

Bevorzugterweise wird das trainierten Lernverfahrens objektiv evaluiert, indem das Modell f(.) mit einem Testdatenset ($X^{train}y^{train}$) trainiert und im Anschluss die Performanz des trainierten maschinellen Lernverfahrens mit einem Testdatenset ($X^{test}, y^{test}$) mithilfe des Distanzmaßes evaluiert, so dass die erwartete Abweichung der geschätzten und der tatsächlichen Kalibrierwerte über $d(y^{test}, f(X^{test}))$ objektiv angegeben werden kann

Je nach Ausgestaltung und Definition des Input- und Outputdatenraums y und X des maschinelle Lernverfahren, d.h., abhängig von den zum Trainieren des maschinellen Lernverfahrens verwendeten Trainingsdaten können ein Kalibrierwert für die Baugruppe, jeweils ein Kalibrierwert für eine Baugruppenkomponente oder ein Kalibrierwert für mehrere Baugruppenkomponenten und/oder jeweils ein Kalibrierwert für eine Messgröße oder ein Kalibrierwert für mehrere unterschiedliche Messgrößen der Baugruppenkomponente ermittelt werden. Somit sind verschiedene Ausführungsformen des Kalibrierverfahren möglich.

Fig. 4 zeigt eine Ausführungsform des Kalibrierverfahrens, bei dem die Kalibrierwerte im Vorfeld durch das maschinelle Lernverfahren in der Kalibriervorrichtung ermittelt und in der Baugruppe abgespeichert werden. Es erfolgt anschließend nur noch eine Überprüfung der durch die Kalibrierwerte nun erreichten höheren Genauigkeit im Vergleich zu einem Zustand ohne Kalibrierwerte. In diesem Fall befinden sich im Inputdatenraum Daten aus der in der Vergangenheit hergestellten Baugruppen sowie weitere externe Einflussgrößen. Der Outputdatenraum hingegen umfasst alle Kalibrierungsdaten der Baugruppe.

Der obere Teil der Fig. 4 zeigt eine Trainingsanordnung 30 zum Trainieren eines maschinellen Lernmodells 42 anhand von historischen Kalibrierdaten 32, das anschließend in den Fertigungsprozess 40 zur Ermittlung von Kalibrierdaten zu kalibrierenden Baugruppen eingesetzt wird.

In der Trainingsanordnung 30 werden historische Kalibrierwerte 32 von einer Vielzahl von Baugruppen 31, die gleichartig zu den zu kalibrierenden Baugruppen 41 sind, bevorzugt Kalibrierwerte von jeder Baugruppenkomponente 45 der Baugruppe 31 ermittelt. Ein untrainiertes maschinelles Lernverfahren 33 wird mit den historischen Kalibrierwerten 32, die beispielsweise durch Messen ermittelt wurden, und mit weiteren Datenquellen, insbesondere mit fertigungsbedinge 34 und/oder physikalische Eigenschaften ausdrückenden Parametern der Baugruppe 31, trainiert. Die Trainingsdaten können zusätzlich fertigungsbedingte und/oder physikalische Eigenschaften ausdrückende Parameter mindestens eines Bauteils der Baugruppe oder zusätzlich physikalische Eigenschaften ausdrückende Parameter einer Fertigungsumgebung der gleichartigen Baugruppe 31 umfassen.

In der Kalibrieranordnung 40 übermittelt eine zu kalibrierende Baugruppe 41 eine Kalibrierabfragekennung 43 an das in einer Kalibriervorrichtung angeordnete trainierte maschinelle Lernverfahren 42. Die Kalibrierabfragekennung 43 ist mindestens einem der Parameter der Trainingsdaten zuordenbar. Die Kalibrierabfragekennung kann beispielsweise eine Information bezügliche eines verbauten Bauteils der Baugruppe sein und Trainingsdaten zuordenbar sein. Das trainierte maschinelle Lernverfahren 42 ermittelt anhand der Kalibrierabfragekennung 43 einen oder mehrere Kalibrierwerte 44 und übermittelt diese an die zu kalibrierende Baugruppe 41. Umfasst die zu kalibrierende Baugruppe 41 mehr als eine zu kalibrierende Baugruppenkomponente 45 so wird für jede einzelne der Baugruppenkomponenten 45 der Kalibrierwert von der Kalibriervorrichtung ermittelt und an die Baugruppe 41 übermittelt.

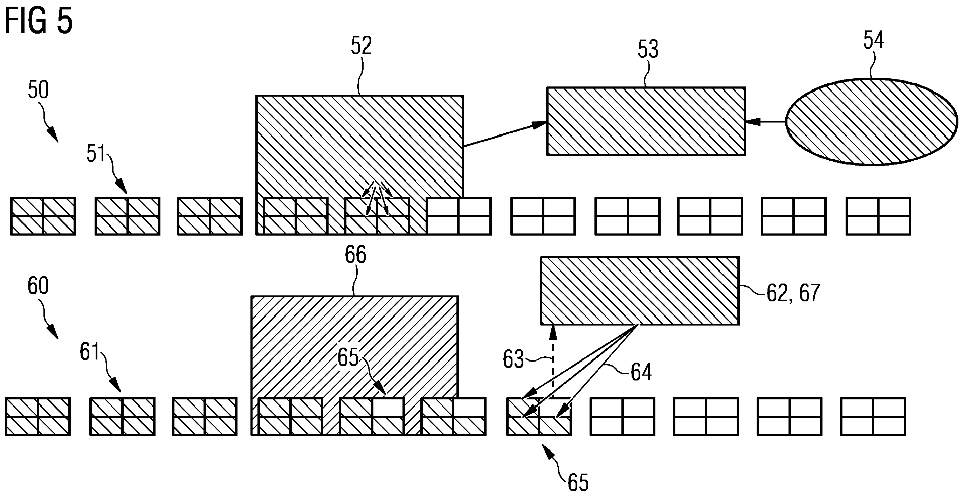

Fig. 5 zeigt eine Kalibrieranordnung 50 für eine weitere Ausführungsform eines Kalibrierverfahrens 60 bei dem ein trainiertes maschinelles Lernverfahren 62 auf Basis von einzelnen mittels eins herkömmlichen Verfahrens ermittelten Kalibrierwerten nun nur für einen Teil der restlichen Komponenten die Kalibrierwerte vorhersagt und somit die Kalibrierzeit anteilig verkürzt. Dementsprechend umfasst der Inputdatenraum des maschinellen Lernverfahrens 62 Daten aus in der Vergangenheit hergestellten Baugruppen sowie Daten der aktuell vorliegenden Baugruppe und optional weitere externe Einflussgrößen. Der Outputdatenraum des maschinellen Lernverfahrens 62 umfasst nun nur einen Teil der Kalibrierungsdaten einer zu kalibrierenden Baugruppe 61.

In der Trainingsanordnung 50 werden historische Kalibrierwerte 52 von einer Vielzahl von Baugruppen 51, die gleichartig zu den zu kalibrierenden Baugruppen 61 sind, bevorzugt Kalibrierwerte von jeder Baugruppenkomponente der Baugruppe 51 ermittelt. Ein untrainiertes maschinelles Lernverfahren 53 wird mit den historischen Kalibrierwerten 52, die beispielsweise durch Messen ermittelt wurden, und mit weiteren Datenquellen, insbesondere mit fertigungsbedingte und/oder physikalische Eigenschaften ausdrückenden Parametern 54 der Baugruppe 51, trainiert. Die Trainingsdaten können zusätzlich fertigungsbedingte und/oder physikalische Eigenschaften ausdrückende Parameter mindestens eines Bauteils der Baugruppe oder zusätzlich physikalische Eigenschaften ausdrückende Parameter einer Fertigungsumgebung der gleichartigen Baugruppe 31 umfassen.

Im Fertigungsprozess 60 wird ein Kalibrierwert für eine der Baugruppenkomponenten 65 der zu kalibrierende Baugruppe 61 in herkömmlicher Weise durch eine Kalibrierstation 66 ermittelt. Die zu kalibrierende Baugruppe 61 übermittelt eine Kalibrierabfragekennung 63 an das in einer Kalibriervorrichtung angeordnete trainierte maschinelle Lernverfahren 62, wobei die Kalibrierabfragekennung 63 den für die Baugruppenkomponenten der zu kalibrierenden Baugruppe ermittelten Kalibrierwert umfasst. Das trainierte maschinelle Lernverfahren 62 ermittelt abhängig von der übermittelten Kalibrierabfragekennung 63 die Kalibrierwerte 64 für die weiteren Baugruppenkomponenten der zu kalibrierenden Baugruppe 65 und übermittelt diese an die Baugruppe 65.

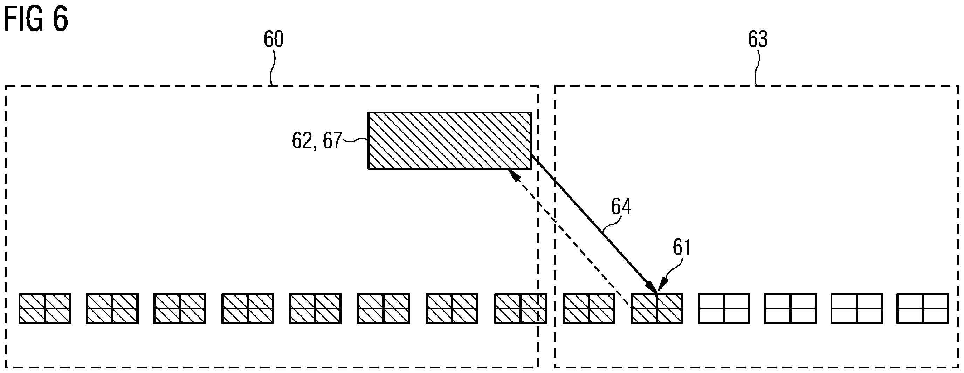

Fig. 6 zeigt eine Variante des Kalibrierverfahrens aus Fig. 4. Ein maschinelles Lernmodell 62, wird entsprechend der Trainingsanordung 30 trainiert. Durch ein maschinelles Lernmodell 62 werden alle nötigen Kalibrierwerte einer zu kalibrierenden Baugruppe 61 während des Fertigungsprozesses 60 in einer Fertigungsanlage ermittelt, an die zu kalibrierende Baugruppe 61 übermittelt und dort gespeichert. Es erfolgt eine Verifikation der Genauigkeit in einer Endkontrolle des Fertigungsprozesses auf Grenzwerte der maximal erreichbaren Genauigkeit. Die mit den gespeicherten Kalibrierwerten erreichte Genauigkeit der kalibrierten Baugruppe 61 und/oder eine erreichte Genauigkeit der kalibrierten Baugruppenkomponenten wird ermittelt und abhängig von der ermittelten Genauigkeit wird ein Gütewert der Baugruppe und/oder der kalibrierten Baugruppenkomponente zugeordnet. Die Baugruppe wird jedoch mit einer niedrigeren Genauigkeitsklasse bzw. Güteklasse ausgeliefert.

Bei Bedarf kann in einzelne Baugruppenkomponenten der Baugruppe 61 oder auch nur einzelne Messbereiche von Baugruppenkomponenten eine höhere Genauigkeit freischalten. Dazu wird anhand der eindeutigen Baugruppenkennung (F-ID) ein Schlüssel generiert, der die schon in der Baugruppe vorhandenen Kalibrierwerte einzeln freischaltet. Der mindestens eine in der Baugruppe 61 gespeicherte Kalibrierwert wird erst nach einer erfolgreichen Freischaltaktion zur Nutzung in der Baugruppe freigeben. Der Kalibrierwert kann für unterschiedliche Zeitspannen freigeschaltet werden. Es ist jeweils ein Kalibrierwert für eine Baugruppenkomponente oder ein Kalibrierwert für mehrere Baugruppenkomponenten und/oder jeweils ein Kalibrierwert für eine Messgröße oder ein Kalibrierwert für mehrere unterschiedliche Messgrößen der Baugruppenkomponente freigebbar. Der mindestens eine Kalibrierwert wird durch Empfangen eines für die Baugruppe 61 spezifischen kryptographischen Schlüssels in der Baugruppe 61 aktiviert. Jeweils ein Kalibrierwert für mehr als eine unterschiedliche Genauigkeitsstufe der Baugruppe 61 werden von der Kalibriervorrichtung ermittelt und auf der Baugruppe gespeichert, und ist auf Anforderung ein von dem auf der Baugruppe aktiver Kalibrierwert unterschiedlicher Kalibrierwert freigebbar.

Vorteilhaft ist dabei, dass einzelne Baugruppenkomponenten, beispielsweise Kanäle, oder einzelne Messbereiche für einen bestimmten Zeitraum bei Bedarf freigeschaltet werden können und damit der Nutzer der Baugruppe 61 mehr Flexibilität gewinnt. Außerdem kann der Nutzer der Baugruppe Kosten einsparen, da er bei einer hohen Genauigkeitsanforderung für wenige Kanäle nicht für alle Kanäle zu dieser Genauigkeitsklasse wechseln muss.

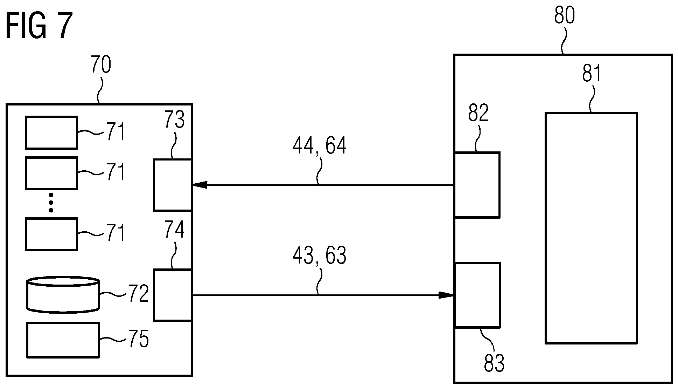

Fig. 7 zeigt ein Ausführungsbeispiel eines Kalibriersystems, das ein Ausführungsbeispiel einer zu kalibrierenden elektronische Baugruppe 70 und ein Ausführungsbeispiel einer Kalibriervorrichtung 80 umfasst.

Die zu kalibrierende elektronische Baugruppe 70 enthält mindestens eine Baugruppenkomponente 71, eine Speichereinheit 72, eine Eingabeschnittstelle 73 und eine Ausgabeschnittstelle 74. Die Eingabeschnittstelle 73 ist derart ausgebildet, einen Kalibrierwert, beispielsweise Kalibrierwert 44, 64 aus Fig. 4, 5, 6, für die Baugruppe 70, der bei einem vorgegebenen Eingabewert eine Abweichung zwischen einem von der Baugruppe 70 bzw. einer der Baugruppenkomponenten 71 ausgegebenen Ist-Ausgabewert und einem vorgegebenen Soll-Ausgabewert angibt, von der Kalibriervorrichtung 80 zu empfangen. Es kann dabei für jede der Baugruppenkomponenten 71 oder für unterschiedliche Messgrößen oder unterschiedliche Messbereiche der Baugruppenkomponenten 71 ein eigener Kalibrierwert empfangen werden.

Die Speichereinheit 72 ist derart ausgebildet, den über die Eingabeschnittstelle 73 empfangenen mindestens einen Kalibrierwert 44, 64 in der Speichereinheit 73 zu speichern. Der Kalibrierwert 44, 64 der Baugruppe 70 wurde mittels eines in der Kalibriervorrichtung 80 ausgeführten maschinellen Lernverfahrens ermittelt, wobei das maschinelle Lernverfahren anhand von Trainingsdaten, die historische Kalibrierwerte einer Mehrzahl von gleichartigen Baugruppe sowie fertigungsbedingten und/oder physikalischen Eigenschaften ausdrückenden Parametern der gleichartigen Baugruppen umfassen, trainiert ist.

Die Ausgabeschnittstelle 74 ist derart ausgebildet, eine Kalibrierabfragekennung 43, 63, siehe Fig. 4 und 5, zu erzeugen, der mindestens ein der Parameter der Trainingsdaten zuordenbar ist oder die einen für eine der Baugruppenkomponenten 71 der zu kalibrierenden Baugruppe 70 durch Messen ermittelten Kalibrierwert umfasst. Die Ausgabeschnittstelle 74 sendet die Kalibrierabfragekennung 43, 63 von der Baugruppe 70 an die Kalibriervorrichtung 80.

Jede Baugruppenkomponente 71 ist derart ausgebildet, ein Eingabesignal mit einem Eingabewert zu empfangen und ein Ausgabesignal mit einem Ausgabewert auszugeben. Der Ausgabewert wird abhängig von dem Eingabesignal ermittelt und um den in der Speichereinheit 72 gespeicherten Kalibrierwert korrigiert ausgegeben.

Die Kalibriervorrichtung 80 umfasst eine Kalibriereinheit 81, eine Ausgabeeinheit 82 und eine Eingabeeinheit 83. Die Eingabeeinheit 83 ist derart angeordnet, die Kalibrierabfragekennung 43, 63 zu empfangen.

Die Kalibriereinheit 81 umfasst mindestens einen Prozessor, auf dem das trainierte maschinelle Lernverfahren angeordnet und ausführbar ist. Die Kalibriereinheit 81 ist derart ausgebildet, anhand der Kalibrierabfragekennung 43, 63 oder einem aus der Kalibrierabfragekennung 43, 63 abgeleiteten Kenner den Kalibrierwert 44, 64 für die Baugruppe 70 zu ermitteln. Die Kalibrierabfragekennung 43, 63 wird von der Eingabeeinheit 83 als Eingabewert den maschinelle Lernverfahren in der Kalibriereinheit 81 zugeführt und der ermittelt Kalibrierwert 44, 64 wird an die Ausgabeeinheit 82 ausgegeben. Die Ausgabeeinheit 82 ist derart ausgebildet, den Kalibrierwert 44, 64 an die Baugruppe 70 zu übermitteln.

Die Kalibriervorrichtung 80 kann auch derart ausgebildet sein, das Trainieren des maschinelle Lernverfahrens auszuführen. Dazu werden in der Kalibriervorrichtung 80 Trainingsdaten empfangen, die Kalibrierwerte von einer Vielzahl von gleichartigen Baugruppen, auch historische Kalibrierwerte genannt, und fertigungsbedingten und/oder physikalischen Eigenschaften ausdrückenden Parametern der gleichartigen Baugruppen umfassen. Zur Evaluierung des maschinellen Lernverfahrens können für eine Baugruppe durch das trainierte maschinelle Lernverfahren ermittelte Kalibrierwerte mit gemessenen Kalibrierdaten verglichen werden, und das maschinelle Lernverfahren optimiert werden. Das Trainieren des maschinellen Lernverfahrens kann auch in einer von der Kalibriervorrichtung 80 physisch getrennten Vorrichtung durchgeführt werden und nach dem Trainieren in die Kalibriervorrichtung 80 eingebracht werden.

Alle Verfahrensschritte können durch die entsprechenden Geräte implementiert werden, die zum Ausführen des jeweiligen Verfahrensschrittes geeignet sind. Alle Funktionen, die von gegenständlichen Merkmalen ausgeführt werden können, können ein Verfahrensschritt des Verfahrens sein. Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

**Patentansprüche**

1. Verfahren zur Kalibrierung einer elektronischen Baugruppe während eines Fertigungsprozesses (40, 60), mit den Schritten:

   - Ermitteln (S1) eines Kalibrierwertes (44, 64) für die Baugruppe (41, 61), der bei einem vorgegebenen Eingabewert eine Abweichung zwischen einem von der Baugruppe (41, 61) ausgegebenen Ist-Ausgabewert und einem vorgegebenen Soll-Ausgabewert angibt,
   - Übermitteln (S2) des Kalibrierwertes an (44, 64) die Baugruppe (41, 61), und
   - Speichern (S3) des Kalibrierwertes (44, 64) in der Baugruppe (41, 61),

   wobei der Kalibrierwert (44, 64) der Baugruppe (41, 61) mittels eines in einer Kalibriervorrichtung (47, 67) ausgeführten maschinellen Lernverfahrens (42, 62) ermittelt wird, und das maschinelle Lernverfahren (42, 62) anhand von Trainingsdaten, die historische Kalibrierwerte (32, 52) einer Mehrzahl von gleichartigen Baugruppen sowie fertigungsbedingte und/oder physikalische Eigenschaften ausdrückende Parameter (34, 54) der gleichartigen Baugruppen umfassen, trainiert ist.

2. Verfahren nach Anspruch 1, wobei die Trainingsdaten zusätzlich fertigungsbedingte und/oder physikalische Eigenschaften ausdrückende Parameter mindestens eines Bauteils der gleichartigen Baugruppe umfassen.

3. Verfahren nach einem der vorangehenden Ansprüche, wobei die Trainingsdaten zusätzlich physikalische Eigenschaften ausdrückende Parameter einer Fertigungsumgebung der gleichartigen Baugruppe umfassen.

4. Verfahren nach einem der vorangehenden Ansprüche, wobei die Baugruppe (41, 61) mehr als eine zu kalibrierende Baugruppenkomponente (45, 65) umfasst und für jede einzelne der Baugruppenkomponenten (45, 65) der Kalibrierwert (44, 64) von der Kalibriervorrichtung (47, 67) ermittelt und an die Baugruppe (41, 61) übermittelt wird.

5. Verfahren nach einem der vorangehenden Ansprüche, wobei eine Kalibrierabfragekennung (43, 63) von der zu kalibrierenden Baugruppe (41, 61) in der Kalibriervorrichtung (47, 67) empfangen wird und der Kalibrierwert (44, 64) abhängig von der übermittelten Kalibrierabfragekennung (43, 63) von der Kalibriervorrichtung (47, 67) an die zu kalibrierende Baugruppe (41, 61) übermittelt wird, wobei die Kalibrierabfragekennung (43, 63) mindestens einem der Parameter der Trainingsdaten zuordenbar ist.

6. Verfahren nach einem der vorhergehenden Ansprüche, wobei eine Kalibrierabfragekennung (43, 63) von der zu kalibrierenden Baugruppe (41, 61) in der Kalibriervorrichtung (47, 67) empfangen wird und der Kalibrierwert (44, 64) abhängig von der übermittelten Kalibrierabfragekennung (43, 63) von der Kalibriervorrichtung (47, 67) an die zu kalibrierende Baugruppe (41, 61) übermittelt wird, wobei die Kalibrierabfragekennung (43, 63) einen für eine der Baugruppenkomponenten (45, 65) der zu kalibrierenden Baugruppe (41, 61) durch Messen ermittelten Kalibrierwert umfasst.

7. Verfahren nach einem der vorangehenden Ansprüche, wobei eine mit dem gespeicherten Kalibrierwert erreichte Genauigkeit der kalibrierten Baugruppe (41, 61) und/oder erreichte Genauigkeit der kalibrierten Baugruppenkomponente (45, 65) ermittelt wird und abhängig von der ermittelten Genauigkeit ein Gütewert der Baugruppe (41, 61) und/oder der kalibrierten Baugruppenkomponente (45, 65) zugeordnet wird.

8. Verfahren nach einem der vorangehenden Ansprüche, wobei der mindestens eine in der Baugruppe (41, 61) gespeicherte Kalibrierwert (44, 64) erst nach einer erfolgreichen Freischaltaktion zur Nutzung in der Baugruppe (41, 61) freigeben wird.

9. Verfahren nach einem der Ansprüche 4-8, wobei jeweils ein Kalibrierwert (44, 64) für eine Baugruppenkomponente (45, 65) oder ein Kalibrierwert (44, 64) für mehrere Baugruppenkomponenten (45, 65) und/oder jeweils ein Kalibrierwert (44, 64) für eine Messgröße oder ein Kalibrierwert (44, 64) für mehrere unterschiedliche Messgrößen der Baugruppenkomponente (45, 65) freigebbar ist.

10. Verfahren nach Anspruch 8 oder 9, wobei der mindestens eine Kalibrierwert (44, 64) durch Empfangen eines kryptographischen Schlüssels in der Baugruppe (41, 61) aktiviert wird.

11. Verfahren nach einem der vorangehenden Ansprüche, wobei jeweils ein Kalibrierwert (44, 64) für mehr als eine unterschiedliche Genauigkeitsstufe der Baugruppe von der Kalibriervorrichtung (47, 67) ermittelt und auf der Baugruppe (41, 61) gespeichert werden, und auf Anforderung ein von dem auf der Baugruppe aktiver Kalibrierwert unterschiedlicher Kalibrierwert freigebbar ist.

12. Kalibriervorrichtung (47, 67, 80) zur Kalibrierung einer elektronischen Baugruppe (41, 61, 70) während eines Fertigungsprozesses, umfassend

    - eine Kalibriereinheit (81), die derart ausgebildet ist, einen Kalibrierwert (44, 64), der bei einem vorgegebenen Eingabewert eine Abweichung zwischen einem von der Baugruppe ((41, 61, 70) ausgegebenen Ist-Ausgabewert und einem vorgegebenen Soll-Ausgabewert angibt, für die Baugruppe (41, 61, 70) zu ermitteln, und
    - eine Ausgabeeinheit (82), die derart ausgebildet ist,

den Kalibrierwert (44, 64) an die Baugruppe (41, 61, 70) zu übermitteln,
wobei der Kalibrierwert (44, 64) der Baugruppe (41, 61, 70) mittels eines in der Kalibriervorrichtung (47, 67, 80) ausgeführten maschinellen Lernverfahrens (42, 62) ermittelt wird, und das maschinelle Lernverfahren (42, 62) anhand von Trainingsdaten, die historische Kalibrierwerte (32, 52) einer Mehrzahl von gleichartigen Baugruppen sowie fertigungsbedingte und/oder physikalische Eigenschaften ausdrückende Parameter (34, 54) der gleichartigen Baugruppen umfassen, trainiert ist.

13. Elektronische Baugruppe (41, 61, 70), umfassend

    - eine Eingabeschnittstelle (73), die derart ausgebildet ist, einen Kalibrierwert (44, 64) für die Baugruppe (41, 61, 70), der bei einem vorgegebenen Eingabewert eine Abweichung zwischen einem von der Baugruppe (41, 61, 70) ausgegebenen Ist-Ausgabewert und einem vorgegebenen Soll-Ausgabewert angibt, von einer Kalibriervorrichtung (47, 67, 80) zu empfangen,
    - eine Speichereinheit (72), die derart ausgebildet ist, den Kalibrierwert (44, 64) in der Baugruppe (41, 61, 70) zu speichern,
wobei der Kalibrierwert (44, 64) der Baugruppe (41, 61, 70) mittels eines in der Kalibriervorrichtung (47, 67, 80) ausgeführten maschinellen Lernverfahrens (42, 62) ermittelt wird, und das maschinelle Lernverfahren (42, 62) anhand von Trainingsdaten, die historische Kalibrierwerte (32, 52) einer Mehrzahl von gleichartigen Baugruppe sowie fertigungsbedingten und/oder physikalischen Eigenschaften ausdrückenden Parametern (34, 54) der gleichartigen Baugruppen umfassen, trainiert ist, und
    - eine Ausgabeschnittstelle (74), die derart ausgebildet ist, eine Kalibrierabfragekennung (43, 63) von der Baugruppe (41, 61, 70) an die Kalibriervorrichtung (47, 67, 80) zu senden, wobei dem Kalibrierabfragekennung (43, 63) mindestens einer der Parameter der Trainingsdaten zuordenbar ist.

14. Kalibriersystem, umfassend eine Kalibriervorrichtung (47, 67, 80) gemäß Anspruch 12 und mindesten eine zu kalibrierende Baugruppe (41, 61, 70) gemäß Anspruch 13, die derart ausgebildet sind das Verfahren gemäß den Ansprüchen 1-11 auszuführen.

15. Computerprogrammprodukt, umfassend ein nicht flüchtiges computerlesbares Medium, das direkt in einen Speicher eines digitalen Computers ladbar ist, umfassend Programmcodeteile, die bei Ausführung der Programmcodeteile durch den digitalen Computer diesen veranlassen, die Schritte des Verfahrens nach einem der Ansprüche 1 bis 11 durchzuführen.

FIG 1

FIG 2

EP 4 224 178 A1

FIG 3

FIG 4

FIG 5

EP 4 224 178 A1

FIG 6

EP 4 224 178 A1

FIG 7

Europäisches Patentamt

European Patent Office

Office européen des brevets

# EUROPÄISCHER RECHERCHENBERICHT

**Nummer der Anmeldung**

**EP 22 15 4952**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 699 07 930 T2 (EM MICROELECTRONIC MARIN SA [CH]; ADVANCED TECH MATERIALS [US]) 13. Mai 2004 (2004-05-13) | 13 | INV. G01R31/28 G01R31/316 |
| A | * Absätze [0003], [0004], [0007], [0011], [0015], [0030], [0036] *<br>----- | 1-12,14, 15 | |
| A | DE 10 2019 104084 A1 (AXING AG [CH]) 20. August 2020 (2020-08-20) * Absätze [0001], [0004] *<br>----- | 1-15 | |
| A | US 2003/002562 A1 (YERLIKAYA Y DENIS [US] ET AL) 2. Januar 2003 (2003-01-02) * Absätze [0017], [0022], [0024] *<br>----- | 1-15 | |
| A | DE 10 2019 206859 A1 (ZAHNRADFABRIK FRIEDRICHSHAFEN [DE]) 19. November 2020 (2020-11-19) * Absätze [0007], [0008], [0012] – [0016], [0025] – [0027] *<br>----- | 1-15 | |
| A | CN 111 929 569 A (SHENZHEN INJOINIC TECH CO LTD) 13. November 2020 (2020-11-13) * Zusammenfassung *<br>----- | 1-15 | **RECHERCHIERTE SACHGEBIETE (IPC)**<br><br>G01R |

Der vorliegende Recherchenbericht wurde für alle Patentansprüche erstellt

| Recherchenort | Abschlußdatum der Recherche | Prüfer |
|---|---|---|
| München | 22. Juli 2022 | Bossen, Michael |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 22 15 4952

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

22-07-2022

| Im Recherchenbericht angeführtes Patentdokument | Datum der Veröffentlichung | Mitglied(er) der Patentfamilie | | Datum der Veröffentlichung |
|---|---|---|---|---|
| DE 69907930 T2 | 13-05-2004 | AT | 240550 T | 15-05-2003 |
| | | DE | 69907930 T2 | 13-05-2004 |
| | | EP | 1111508 A1 | 27-06-2001 |
| | | JP | 4754686 B2 | 24-08-2011 |
| | | JP | 2001235517 A | 31-08-2001 |
| | | US | 2001007091 A1 | 05-07-2001 |
| DE 102019104084 A1 | 20-08-2020 | KEINE | | |
| US 2003002562 A1 | 02-01-2003 | AT | 442575 T | 15-09-2009 |
| | | BR | 0210603 A | 10-08-2004 |
| | | CA | 2451649 A1 | 09-01-2003 |
| | | DK | 1409978 T3 | 30-11-2009 |
| | | EP | 1409978 A1 | 21-04-2004 |
| | | ES | 2330200 T3 | 07-12-2009 |
| | | JP | 2004533618 A | 04-11-2004 |
| | | KR | 20040039205 A | 10-05-2004 |
| | | MX | PA03011963 A | 03-06-2004 |
| | | US | 2003002562 A1 | 02-01-2003 |
| | | US | 2005249263 A1 | 10-11-2005 |
| | | WO | 03002966 A1 | 09-01-2003 |
| DE 102019206859 A1 | 19-11-2020 | KEINE | | |
| CN 111929569 A | 13-11-2020 | CN | 111929569 A | 13-11-2020 |
| | | CN | 114203570 A | 18-03-2022 |

Für nähere Einzelheiten zu diesem Anhang : siehe Amtsblatt des Europäischen Patentamts, Nr.12/82